(19) **Europäisches Patentamt**

**European Patent Office**

**Office européen des brevets**

(11) **EP 0 645 639 B1**

(12) **EUROPEAN PATENT SPECIFICATION**

(45) Date of publication and mention
of the grant of the patent:
**19.04.2000 Bulletin 2000/16**

(51) Int. Cl.⁷: **G01R 31/28**

(21) Application number: **94115182.1**

(22) Date of filing: **27.09.1994**

(54) **Semiconductor integrated circuit apparatus having self testing function**

Integrierte Halbleiterschaltung mit Selbsttestfunktion

Circuit semi-conducteur intégré avec fonction de test

(84) Designated Contracting States:
**DE FR GB**

(30) Priority: **27.09.1993 JP 23934193**

(43) Date of publication of application:
**29.03.1995 Bulletin 1995/13**

(73) Proprietor: **NEC CORPORATION**
**Tokyo (JP)**

(72) Inventor: **Ogawa, Hisao**
**Minato-ku, Tokyo (JP)**

(74) Representative: **Betten & Resch**
**Reichenbachstrasse 19**
**80469 München (DE)**

(56) References cited:
**EP-A- 0 242 854**

**Description**

This invention relates to a semiconductor integrated circuit apparatus, and more particularly to a semiconductor integrated circuit apparatus which includes means for testing the performance of semiconductor devices for each chip.

In recent years, semiconductor integrated circuit apparatus have exhibited remarkable progresses in terms of integration, density and performance, and as such progresses proceed, various problems in production arise. One of such problems is an increase in dispersion of a circuit performance arising from a dispersion of a device characteristic upon production. While particularly the operation speed is a circuit performance for which the demand by customers is high, the frequency of appearance of products which operate but not at a satisfactory speed is increasing. Another problem resides in that, while such dispersion of a circuit performance can be reduced by employing more severe specifications for production of a wafer, even with employment of such severe specifications, it becomes more and more difficult for all chips on an entire face of a semiconductor wafer to satisfy all of the specifications in production. Consequently, it becomes more and more necessary to try to change the manner of control in production from the control in units of a wafer, which has conventionally employed popularly, to the control in units of a chip. In other words, the requirement for testing for each individual chip whether or not characteristics of devices remain within the production specifications is increasing.

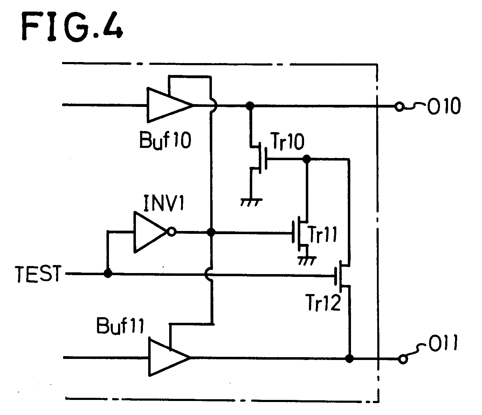

One of semiconductor integrated circuit apparatus which satisfy the requirement described above is disclosed in Japanese Patent Laid-Open Application No. Heisei 2-140947 (Japanese Patent Application No. Showa 63-295012). The circuit construction of the semiconductor integrated circuit apparatus is shown in FIG. 4. Referring to FIG. 4, the semiconductor integrated circuit apparatus includes a transistor Tr10 connected between an external terminal 010 and a grounding line and making an object for testing, another transistor Tr12 connected between another external terminal O11 and the gate electrode of the transistor Tr10, and a further transistor Tr11 connected between the gate electrode of the transistor Tr10 and the grounding line. One of the transistor Tr12 and the transistor Tr11 is turned on by "0" or "1" of a testing signal TEST. When the transistor Tr12 is turned on, a drain voltage (current) and a gate voltage is applied to the transistor Tr10 from the external terminal O10 and the external terminal O11, respectively, to measure a characteristic of the transistor Tr10 as an object for testing. On the other hand, when the transistor Tr11 is turned on, the transistor transistor Tr10 is turned off to activate output buffers Buf10 and Buf11 so that output signals of the output buffers Buf10 and Buf11 are outputted to the external terminal O10 and external terminal O11.

The semiconductor integrated circuit apparatus has the following problems.

The first problem resides in that, in order to make a measurement of a transistor as an object for testing, an external input terminal for providing a testing signal from the outside of the chip is required. In semiconductor integrated circuit apparatus at present days, since progresses in high integration and increase of functions advance and the number of external terminals is progressively increasing, it should be avoided to use even one external terminal for measurement of a characteristic of a transistor.

The second problem resides in that, in order to make a measurement of a characteristic of a transistor as an object for testing, testing equipments such as an analog signal source and an analog tester are required. Particularly since inputting and measurement of analog signals are involved, a countermeasure against noise from a testing equipment upon measurement is difficult, and for such countermeasure, a higher degree of accuracy of and a higher cost for the testing equipment itself are required. Further, as progresses in integration and in increase of functions advance, the testing time increases, which makes a factor of a rise in production cost of a semiconductor integrated circuit apparatus. Therefore, a measurement with an analog signal which requires a longer measurement time than another measurement with a digital signal should be avoided.

Document EP-A-0 242 854 shows an integrated semiconductor memory device, in which an on-chip testing circuit includes testing cells and a reference cell of identical structure. The testing circuit identifies defective cells by comparing the testing cells with the reference cell and outputs a signal representative of the test result.

It is an object of the present invention to provide a semiconductor integrated circuit apparatus which can perform a test of a characteristic of a semiconductor device on a chip by itself readily in a short time.

It is another object of the present invention to provide a semiconductor integrated circuit apparatus wherein a self test for each chip can be performed economically using a simple additional circuit.

In order to attain the objects described above, according to the present invention, there is provided a semiconductor integrated circuit apparatus having a self testing function, which comprises a signal processing circuit including a plurality of semiconductor devices integrated on a chip, and a testing circuit provided on the chip and including a testing semiconductor device having an equal size to that of at least one of the semiconductor devices and a reference semiconductor device having a different size from that of the testing semiconductor device, the testing circuit being constructed so as to compare characteristics of the testing semiconductor device and the reference semiconductor device with each other and output a signal representative of a result of the comparison.

In the semiconductor integrated circuit apparatus, the testing semiconductor device represents the semiconductor devices constituting the signal processing circuit, and if the semiconductor devices constituting the signal processing circuit suffer, upon production of a wafer, from a size fluctuation from a designed size, then also the testing semiconductor device suffers from a similar size variation, and a dispersion in characteristic appears by an amount corresponding to the size variation. Thus, if a characteristic is compared between the testing semiconductor device and the reference semiconductor device on the same chip, for example, if characteristics of the testing semiconductor device and the reference semiconductor device are compared with each other to determine whether the characteristic of the testing semiconductor device exceeds or is lower than the characteristic of the reference semiconductor device, then acceptability of the chip can be determined by the chip itself.

In order to drive, upon testing, the testing semiconductor device and the reference semiconductor device in a same condition as that of the semiconductor devices constituting the signal processing circuit, the testing circuit and the signal processing circuit are placed in a substantially same electric connection condition. In order to reduce the later power consumption of the chip, which has been determined by a test by the testing circuit, by the testing circuit to zero, preferably the semiconductor integrated circuit apparatus having a self testing function further comprises interruption means capable of interrupting the testing circuit from the power source line on the chip.

If the output of the signal processing circuit is controlled in response to the comparison result signal from the testing circuit, then acceptability of the chip can be determined from an result of an output terminal of the signal processing circuit. Or, the testing circuit may have an output terminal for outputting the comparison result signal to the outside.

Where the semiconductor devices constituting the signal processing circuit, the testing semiconductor device and the reference semiconductor device are MOS transistors, the size of the gate of the testing semiconductor device is made different from the size of the reference semiconductor device.

The reference MOS transistor and the testing MOS transistor may be designed such that the length and the width of the gate of the reference MOS transistor are greater than the length and the width of the gate of the testing MOS transistor and the mutual conductance of the reference MOS transistor is equal to that of the testing MOS transistor, and the testing circuit may include a comparison circuit for comparing the magnitudes of the drain current of the reference MOS transistor and the drain current of the testing MOS transistor with each other. The comparison circuit may include a plurality of current mirror circuits each including a combination of a pair of MOS transistors.

The above and other objects, features and advantages of the present invention will become apparent from the following description and the appended claims, taken in conjunction with the accompanying drawings in which like parts or elements are denoted by like reference characters.

FIG. 1(a) is a block diagram of a semiconductor integrated circuit apparatus showing a first preferred embodiment of the present invention;
FIG. 1(b) is a circuit diagram of a testing circuit in the semiconductor integrated circuit apparatus shown in FIG. 1(a);
FIG. 2 is a characteristic diagram of the relationship between the gate length and the threshold voltage illustrating a characteristic of a MOS transistor;
FIG. 3 is a block diagram of another semiconductor integrated circuit apparatus showing a second preferred embodiment of the present invention; and
FIG. 4 is a block diagram showing a conventional semiconductor integrated circuit diagram.

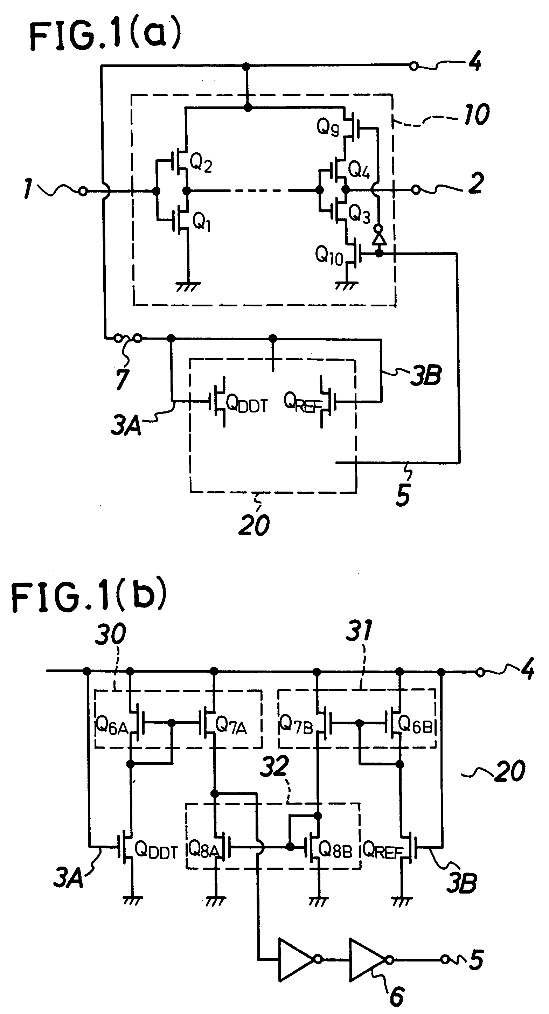

Referring first to FIG. 1(a), there is shown a semiconductor integrated circuit apparatus according to a first preferred embodiment of the present invention. The semiconductor integrated circuit apparatus shown includes a signal processing circuit 10 having an input terminal 1 to which a predetermined logic input signal is applied from the outside and an output terminal 2 for outputting therethrough to the outside a logic signal obtained by processing the logic input signal, and a testing circuit 20 for testing a performance of transistors $Q_1$, $Q_2$, $Q_3$ and $Q_4$ which constituted the signal processing circuit 10. The signal processing circuit 10 and the testing circuit 20 are provided on a same chip.

The testing circuit 20 includes a testing MOS transistor $Q_{DDT}$ having an equal size as that of at least one of the transistors $Q_1$, $Q_2$, $Q_3$ and $Q_4$, and a reference MOS transistor $Q_{REF}$ for providing a reference in comparison in performance. Here, the description that a transistor has an equal size signifies that, in regard to a MOS transistor, it has at least an equal gate length and an equal gate width. It is to be noted that, while the signal processing circuit 10 normally receives a plurality of input signals and generates a plurality of output signals, it is shown in FIG. 1(a) such that it has a single input terminal and a single output terminal in order to simplify illustration and description.

A detailed construction of the testing circuit 20 is shown in FIG. 1(b). Referring to FIG. 1(b), the testing circuit 20 shown includes a comparison circuit formed from three current mirror circuits 30, 31 and 32. The first current mirror circuit 30 includes a pair of transistors $Q_{6A}$ and $Q_{7A}$ and is connected to the testing MOS transistor $Q_{DDT}$ which serves as an input side current source to the first current mirror circuit 30; the second current mirror circuit 31 includes a pair of transistors $Q_{7B}$ and $Q_{6B}$ and is connected to the reference MOS transistor $Q_{REF}$ which serves as an input side current source to the second current mirror circuit 31; and the third current mirror circuit 32 includes a pair of transistors $Q_{8A}$ and $Q_{8B}$ and is connected to the output side transistor $Q_{7B}$ of the current mirror circuit 31 which serves as an input side current source to the third current mirror circuit 32. A same gate bias voltage is applied from a high potential power source line 4 to the gate electrode of the testing MOS transistor $Q_{DDT}$ and the gate electrode of the reference MOS transistor $Q_{REF}$ while a current output terminal of the current mirror circuit 30 and a current output terminal of the current mirror circuit 32 are connected to each other to make an output terminal 5, and a binary signal representative of a result of comparison may be extracted from the output terminal 5 by way of an invertor 6.

In particular, in the testing circuit 20, comparison in characteristic is performed between the reference MOS transistor $Q_{REF}$ and the testing MOS transistor $Q_{DDT}$ which represents the MOS transistors in the signal processing circuit 10, and if the characteristic of the testing MOS transistor $Q_{DDT}$ is equal to or higher than the characteristic of the reference MOS transistor $Q_{REF}$, then the testing circuit 20 determines that the testing MOS transistor $Q_{DDT}$ satisfies the production specifications, but on the contrary if the characteristic of the testing MOS transistor $Q_{DDT}$ is lower than the characteristic of the reference MOS transistor $Q_{REF}$, then the testing circuit 20 determines that the testing MOS transistor $Q_{DDT}$ does not satisfy the production specifications. Then, in accordance with the determination, the testing circuit 20 puts the output terminal 2 of the signal processing circuit 10 into one of an output enabled condition or a high impedance condition.

Normally, when it is tried to construct a comparison circuit with such a circuit construction as shown in FIG. 1(b), it is constructed such that two MOS transistors of each current mirror circuit have an equal gate length and an equal gate width. This is because it is intended that, even if the gate lengths and the gate widths of MOS transistors are displaced from individual designed values due to a dispersion in the production process, each two MOS transistors paired with each other may have an equal mutual conductance and hence the circuit symmetry may be maintained. For example, in the arrangement shown in FIG. 1(b), the transistor $Q_{6A}$ and the transistor $Q_{6B}$ are formed in an equal size; the transistors $Q_{7A}$ and $Q_{7B}$ are formed in an equal size; and the transistors $Q_{8A}$ and $Q_{8B}$ are formed in an equal size; and besides, the testing MOS transistor $Q_{DDT}$ and reference MOS transistor $Q_{REF}$ are formed in an equal size. Generally, with the comparison circuit having the circuit construction described above, a signal is inputted to input terminals 3A and 3B shown in FIG. 1(a) and resulted signals are compared in magnitude with each other, and a logic signal of "1" or "0" is outputted from the output terminal 5 (output terminal of the invertor 6) in accordance with a result of the comparison.

In contrast, in the comparison circuit employed in the present embodiment, different from an ordinary method of use wherein the magnitudes of two input signals are compared, a difference between drain currents of the testing MOS transistor $Q_{DDT}$ and the reference MOS transistor $Q_{REF}$ is detected, and to this end, a common potential is applied to the two input terminals 3A and 3B. In the present embodiment, the gate electrodes of the testing MOS transistor $Q_{DDT}$ and reference MOS transistor $Q_{REF}$ are connected to the high potential power source line 4. Further, the gate width and the gate length of the testing MOS transistor $Q_{DDT}$ are equal to those of one of the actual transistors $Q_1$, $Q_2$, $Q_3$ and $Q_4$ used in the signal processing circuit 10, and besides the testing MOS transistor $Q_{DDT}$ and the reference MOS transistor $Q_{REF}$ are designed such that the mutual conductances thereof may be substantially equal to each other, that is, the ratios (W/L) between the gate width W and the gate length L may be substantially equal to each other. However, the absolute values of the dimensions are set such that the gate width and the gate width of the reference MOS transistor $Q_{REF}$ is much greater than those of the testing MOS transistor $Q_{DDT}$. This is because it is intended that, even if the gate width and the gate length of each transistor are displaced from individual designed values, the reference MOS transistor $Q_{REF}$ is not influenced by such displacement and maintains a predetermined mutual conductance as a reference in comparison.

This will be described in more detail. Now, if the drain current of the testing MOS transistor $Q_{DDT}$ is represented by i1 and the drain current of the reference MOS transistor $Q_{REF}$ is represented by i2, since the source potentials and the gate potentials of the two transistors are conditioned as described above, when the mutual conductances of the two transistors are equal to each other, naturally i1 = i2 . Since the mutual conductance depends upon the ratio (W/L) between the effective gate width and the effective gate length, even if the gate width and the gate length of the reference MOS transistor $Q_{REF}$ are set to values equal to n times the gate width and the gate length of the testing MOS transistor $Q_{DDT}$, respectively, the mutual conductances of the two transistors are equal to each other. For example, even if the gate width of the testing MOS transistor $Q_{DDT}$ is set to 5 µm and the gate length is set to 1 µm while the gate width of the reference MOS transistor $Q_{REF}$ is set to 50 µm and the gate length is set to 10 µm, the mutual conductances of the two transistors are equal to each other, and consequently, i1 = i2 .

However, if the gates of the testing MOS transistor $Q_{DDT}$ and the reference MOS transistor $Q_{REF}$ have different sizes, then the drain currents i1 and i2 are not always equal to each other due to a dispersion in the process of production. For example, if the gate widths of the two transistors decrease equally by 0.1 µm and the gate lengths decrease equally by 0.1 $\mu$m, then the mutual conductance of the testing MOS transistor $Q_{DDT}$ is 4.9/0.9 = 5.44 while the mutual conductance of the reference MOS transistor $Q_{REF}$ is 49.9/9.9 = 5.04 , and accordingly, the mutual conductance of the testing MOS transistor $Q_{DDT}$ is higher by about 8 % than that of the reference MOS transistor $Q_{REF}$. While the increment does not directly make the difference between the drain currents i1 and i2, anyway the drain current i1 is higher than the drain current i2. Therefore, according to the present invention, the balance in operation of a comparison circuit is broken making use of such a nature as described above to extract a difference in characteristic between the two transistors.

In the following, operation of the semiconductor integrated circuit apparatus of the present embodiment will be described in connection with a determination method for a transistor characteristic by way of an example of a case wherein the gate length of a MOS transistor becomes shorter than a designed value therefor during a process for a wafer so that the performance of the transistor is displaced from its designed value.

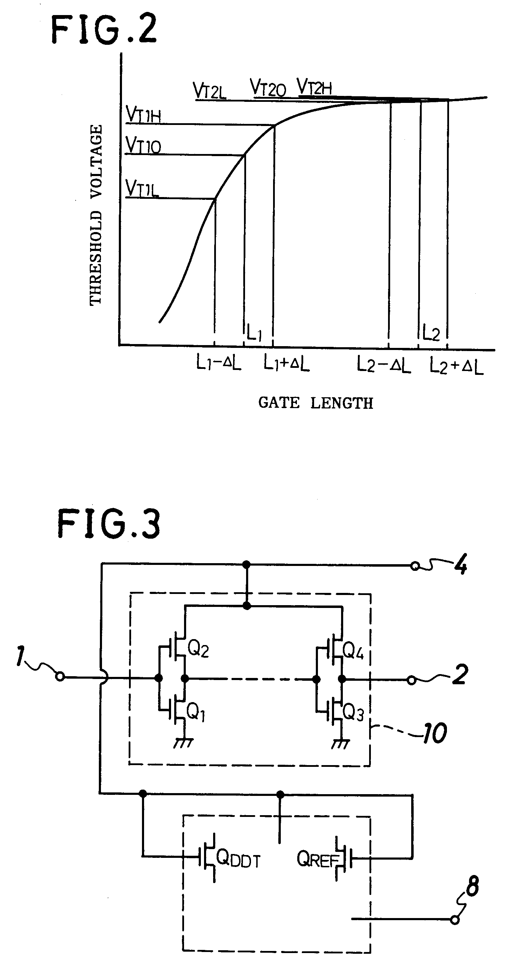

FIG. 2 illustrates the relationship between the gate length and the threshold voltage of a MOS transistor. Referring to FIG. 2, the gate length $L_1$ is applied to the MOS transistors in the signal processing circuit 10 and the testing MOS transistor $Q_{DDT}$ in the testing circuit 20 and is, for example, 0.5 $\mu$m. The gate length $L_2$ is applied to the reference MOS transistor $Q_{REF}$ and is, for example, 5 $\mu$m. $\Delta L$ represents an allowable width of the dispersion appearing in the wafer process and is, for example, 0.05 $\mu$m. Where the threshold voltage $V_{T1\emptyset}$ when the gate length is $L_1$ is, for example, 0.6 V, the threshold voltages $V_{T1L}$, $V_{T1H}$, $V_{T2L}$, $V_{T2\emptyset}$ and $V_{T2H}$ when the gate length is $L_1 - \Delta L$, $L_1 + \Delta L$, $L_2 - \Delta L$, $L_2$ and $L_2 + \Delta L$ are 0.45 V, 0.7 V, 0.895 V, 0.90 V and 0.905 V, respectively. In this instance, when the power source voltage is 3.3 V, the width of the dispersion of the mutual conductance which represents a performance of a MOS transistor ranges from +24 % to -16 % with a transistor of the gate length $L_1$, but ranges between ±1.5 % with another transistor of the gate length $L_2$.

If the gate length of a MOS transistor decreases, the leak current increases and the device life time decreases, and accordingly, a lower limit must be provided from the point of view of prevention of a malfunction and quality assurance. In the present example, the lower limit must be set to a value equal to or higher than 0.45 $\mu$m or preferably to a value equal to or higher than 0.47 $\mu$m. On the other hand, if the gate length increases, another problem that the speed of circuit operation drops arises, and accordingly, the gate length must be controlled with the production specification of less than 0.55 $\mu$m and preferably less than 0.53 $\mu$m as an upper limit. In the present embodiment, the dispersion amount of the gate length is detected to determine acceptability of the transistor characteristic making use of the fact that the threshold voltage of a MOS transistor is varied by variation of the gate length and the amount of the variation differs whether the gate length is long or short as seen from FIG. 2.

It is assumed now that the gate lengths of the MOS transistors of FIG. 1(b) designed with $L_1$ = 0.5 $\mu$m become smaller than the lower limit value 0.45 $\mu$m. The testing MOS transistor $Q_{DDT}$ is designed with the gate length $L_1$ = 0.50 $\mu$m and the gate width 5.0 $\mu$m while the reference MOS transistor $Q_{REF}$ is designed with the gate length $L_2$ = 5.0 $\mu$m and the gate width 62 $\mu$m. In this instance, when the transistor size does not have a dispersion in production, the mutual conductance of the testing MOS transistor $Q_{DDT}$ becomes lower than the mutual conductance of the reference MOS transistor $Q_{REF}$, and consequently, the drain current of about 1.24 times the drain current which flows through the testing MOS transistor $Q_{DDT}$ flows through the reference MOS transistor $Q_{REF}$ and a logic output signal "1" appears at the output terminal 5. In the circuit shown in FIG. 1(a), the transistors $Q_9$ and $Q_{1\emptyset}$ which constitute a tri-state buffer at an output stage are put into an on-state by a "1" signal indicating that the characteristic of the testing MOS transistor $Q_{DDT}$ satisfies the specifications. In other words, the output tri-state buffer is activated, and an output signal corresponding to the input signal to the input terminal 1 appears at the output terminal 2.

Meanwhile, if a dispersion in manufacture occurs in the wafer process so that the gate length of the testing MOS transistor $Q_{DDT}$ becomes 0.45 $\mu$m and the gate length of the reference MOS transistor $Q_{REF}$ becomes 4.95 $\mu$m, the mutual conductances of the two MOS transistors $Q_{DDT}$ and $Q_{REF}$ become equal to each other. As the gate length further decreases, the relationship between the mutual conductances of the two MOS transistors $Q_{DDT}$ and $Q_{REF}$ is reversed, and as a result, the mutual conductance of the testing MOS transistor $Q_{DDT}$ becomes higher. In this instance, the logic output signal at the output terminal 5 changes from "1" to "0" and the external output terminal 2 enters into a high impedance condition, in which outputting from the output terminal 5 is inhibited.

As apparent from the foregoing description of operation, in the present embodiment, since the testing circuit 20 tests a characteristic of a MOS transistor having an equal size to that of the transistors used in the signal processing circuit 10 so that the MOS transistor may represent the transistors, there is no need of inputting from the outside a signal for exclusive use for operating the signal processing circuit 10 (for example, the testing signal TEST for the conventional integrated circuit apparatus shown in FIG. 4). Further, since the result of the test appears as a binary signal of "1" or "0" and this signal determines acceptability of the output of the output terminal 2 of the signal processing circuit 10, special testing means such as an analog signal source or an analog tester is not required at all. In other words, the semiconductor integrated circuit can determine acceptability of the transistor characteristic for each chip in a wafer without increasing the number of external terminals and without the necessity of an analog signal source and an analog tester.

In this manner, the testing circuit 20 in the present embodiment is constructed such that two MOS transistors $Q_{DDT}$ and $Q_{REF}$ whose ratios between the gate width and the gate length are set close to each other so that they may have substantially equal mutual conductances are disposed at an entrance portion of a comparison circuit and the variation width of the gate length is detected making use of the fact that, when the gate lengths of the MOS transistors $Q_{DDT}$ and $Q_{REF}$ are reduced by an equal amount due to a dispersion in production, the variation of the mutual conductance of the transistor having a smaller gate length is greater than the variation of the mutual conductance of the other transistor having a greater gate length. It is to be noted that preferably the gate lengths of the transistors $Q_{6A}$, $Q_{6B}$, $Q_{7A}$, $Q_{7B}$, $Q_{8A}$ and $Q_{8B}$ are set greater than 3.0 μm in order to minimize the characteristic dispersion of the comparison circuit.

Further, in the present embodiment, a fuse 7 is interposed as interruption means between the power supply line to the testing circuit 20 and the high potential power source line 4. By cutting the fuse 7 after the test of the semiconductor apparatus in the condition of a wafer, the power consumption by the testing circuit 20 can be reduced to zero, and consequently, the power consumption of the entire integrated circuit apparatus can be reduced. A fuse for use with a redundancy circuit of a semiconductor memory device or a like fuse can be used for the fuse 7.

It is to be noted that similar effects can be achieved even if, for example, the transistors $Q_{6A}$ and $Q_{6B}$ in the circuit of FIG. 1(b) are used as a MOS transistor for testing and a MOS transistor for reference. In particular, the testing circuit in this instance is constructed such that it includes a MOS transistor for testing and a MOS transistor for reference, a first current mirror circuit connected to the MOS transistor for testing as an input side transistor thereto, a second current mirror circuit connected to the MOS transistor for reference as an input side transistor thereto, and a third current mirror circuit connected to an output side transistor of the first current mirror circuit as an input side current source thereto, and a current output terminal of the first current mirror circuit and a current output terminal of the third current mirror circuit are connected to each other to make an output terminal and a same gate bias voltage is applied to the gate electrode of the MOS transistor which serves as an input side current source to the first current mirror circuit and the gate electrode of the MOS transistor which serves as an input side current source to the second current mirror circuit.

Subsequently, a semiconductor integrated circuit apparatus according to a second preferred embodiment of the present invention will be described. FIG. 3 shows in block diagram the semiconductor integrated circuit apparatus of the second embodiment of the present invention. Referring to FIG. 3, the semiconductor integrated circuit apparatus of the second embodiment is a modification to and different from the semiconductor integrated circuit apparatus in that the output signal of the testing circuit 20 is extracted to the outside by way of an output terminal 8.

Also with the semiconductor integrated circuit apparatus of the present embodiment, a test of a transistor characteristic is performed similarly as with the semiconductor integrated circuit apparatus of the first embodiment. Thus, an analog signal source and an analog tester for the test are not required. While the semiconductor integrated circuit apparatus of the present embodiment must have one additional output terminal as distinct from the semiconductor integrated circuit apparatus, acceptability of a transistor characteristic can be determined immediately and readily depending upon whether or not the output from the output terminal 8 is "1" or "0". In contrast, with the semiconductor integrated circuit apparatus of the first embodiment, in order to know a result of a test, it is necessary to produce a test pattern using, for example, an LSI tester and apply a predetermined input signal to the input terminal 1 (refer to FIG. 1(a)) of the signal processing circuit 10 to check whether or not a predetermined output signal appears at the output terminal 2. The semiconductor integrated circuit apparatus is advantageous for reduction of the testing time since it is constructed so that a result of a test of a transistor characteristic can be known readily.

Having now fully described the invention, it will be apparent to one of ordinary skill in the art that many changes and modifications can be made thereto without departing from the scope of the invention as set forth herein.

## Claims

1. A semiconductor integrated circuit apparatus having a self testing function and including a signal processing circuit which includes a plurality of semiconductor devices integrated on a chip, wherein a testing circuit (20) is provided on said chip and includes a testing semiconductor device ($Q_{DDT}$) having an equal size to that of at least one of said semiconductor devices ($Q_1$ to $Q_4$) and a reference semiconductor device ($Q_{REF}$), said testing circuit (20) being constructed so as to compare characteristics of said testing semiconductor device ($Q_{DDT}$) and said reference semiconductor device ($Q_{REF}$) with each other and output a signal representative of a result of the comparison,
characterized in that said reference semiconductor device ($Q_{REF}$) has a size different from that of said testing semiconductor device ($Q_{DDT}$).

**2.** A semiconductor integrated circuit apparatus as set forth in claim 1, characterized in that said testing circuit (20) and said signal processing circuit (10) are connected to a common power source line (4) on said chip.

**3.** A semiconductor integrated circuit apparatus as set forth in claim 2, characterized in that it further comprises interruption means (7) capable of interrupting said testing circuit (20) from said power source line (4) on said chip.

**4.** A semiconductor integrated circuit apparatus as set forth in claim 1, characterized in that the output of said signal processing circuit (10) is controlled in response to the comparison result signal from said testing circuit (20).

**5.** A semiconductor integrated circuit apparatus as set forth in claim 1, characterized in that said testing circuit (20) has an output terminal (8) for outputting the comparison result signal to the outside.

**6.** A semiconductor integrated circuit apparatus as set forth in claim 1, characterized in that said semiconductor devices ($Q_1$ to $Q_4$) constituting said signal processing circuit (10), said testing semiconductor device ($Q_{DDT}$) and said reference semiconductor device ($Q_{REF}$) are MOS transistors, and the difference in size between said testing semiconductor device ($Q_{DDT}$) and said reference semiconductor device ($Q_{REF}$) is the the difference in length and width between the gates of the MOS transistors ($Q_{DDT}$, $Q_{REF}$).

**7.** A semiconductor integrated circuit apparatus as set forth in claim 6, characterized in that the reference MOS transistor ($Q_{REF}$) and the testing MOS transistor ($Q_{DDT}$) are designed such that the length and the width of the gate of said reference MOS transistor ($Q_{REF}$) are greater than the length and the width of the gate of said testing MOS transistor ($Q_{DDT}$) and the mutual conductance of said reference MOS transistor ($Q_{REF}$) is substantially equal to that of said testing MOS transistor ($Q_{DDT}$), and said testing circuit (20) includes a comparison circuit (30, 31, 32) for comparing the magnitudes of the drain current of said reference MOS transistor ($Q_{REF}$) and the drain current of said testing MOS transistor ($Q_{DDT}$) with each other.

**8.** A semiconductor integrated circuit apparatus as set forth in claim 7, characterized in that said comparison circuit (30, 31, 32) includes a plurality of current mirror circuits (30, 31, 32) each including a combination of a pair of MOS transistors ($Q_{6A}$, $Q_{7A}$ ; $Q_{6B}$

, $Q_{7B}$ ; $Q_{8A}$ , $Q_{8B}$).

**Patentansprüche**

**1.** Integrierte Halbleiterschaltungsvorrichtung mit einer Selbsttestfunktion und mit einer Signalverarbeitungsschaltung, die eine Vielzahl von auf einem Chip integrierten Halbleitervorrichtungen enthält, wobei eine Testschaltung (20) auf dem Chip vorgesehen ist und eine Test-Halbleitervorrichtung (QDDT) mit einer zu derjenigen von wenigstens einer der Halbleitervorrichtungen (Q1 bis Q4) gleichen Größe und eine Referenz-Halbleitervorrichtung (QREF) enthält, wobei die Testschaltung (20) aufgebaut ist, um Charakteristiken der Test-Halbleitervorrichtung (QDDT) und der Referenz-Halbleitervorrichtung (QREF) miteinander zu vergleichen und ein Signal auszugeben, das ein Ergebnis des Vergleichs darstellt,

dadurch gekennzeichnet, daß die Referenz-Halbleitervorrichtung (QREF) eine Größe hat, die unterschiedlich zu derjenigen der Test-Halbleitervorrichtung (QDDT) ist.

**2.** Integrierte Halbleiterschaltungsvorrichtung nach Anspruch 1, dadurch gekennzeichnet, daß die Testschaltung (20) und die Signalverarbeitungsschaltung (10) an eine gemeinsamen Stromversorgungsleitung (4) auf dem Chip angeschlossen sind.

**3.** Integrierte Halbleiterschaltungsvorrichtung nach Anspruch 2, dadurch gekennzeichnet, daß sie weiterhin eine Unterbrechungseinrichtung (7) aufweist, die die Verbindung zwischen der Testschaltung (20) und der Stromversorgungsleitung (4) auf dem Chip unterbrechen kann.

**4.** Integrierte Halbleiterschaltungsvorrichtung nach Anspruch 1, dadurch gekennzeichnet, daß der Ausgang der Signalverarbeitungsschaltung (10) in Antwort auf das Vergleichsergebnissignal von der Testschaltung (20) gesteuert wird.

**5.** Integrierte Halbleiterschaltungsvorrichtung nach Anspruch 1, dadurch gekennzeichnet, daß die Testschaltung (20) einen Ausgangsanschluß (8) zum Ausgeben des Vergleichsergebnissignals nach außen hat.

**6.** Integrierte Halbleiterschaltungsvorrichtung nach Anspruch 1, dadurch gekennzeichnet, daß die Halbleitervorrichtungen (Q1 bis Q4), die die Signalverarbeitungsschaltung (10), die Test-Halbleitervorrichtung (QDDT) und die Referenz-Halbleitervorrichtung (QREF) bilden, MOS-Transistoren sind, und der Unterschied in bezug auf die Größe zwischen der Test-Halbleitervorrichtung (QDDT) und der Referenz-Halbleitervorrichtung (QREF) der Unterschied in bezug auf eine Länge und eine Breite zwischen den Gates der MOS-Transistoren (QDDT, QREF) ist.

**7.** Integrierte Halbleiterschaltungsvorrichtung nach Anspruch 6, dadurch gekennzeichnet, daß der Referenz-MOS-Transistor (QREF) und der Test-MOS-Transistor (QDDT) derart entworfen sind, daR die Länge und die Breite des Gates des Referenz-MOS-Transistors (QREF) größer als die Länge und die Breite des Gates des Test-MOS-Transistors (QDDT) sind und die Steilheit des Referenz-MOS-Transistors (QREF) im wesentlichen gleich derjenigen des Test-MOS-Transistors (QDDT) ist, und die Testschaltung (20) eine Vergleichsschaltung (30, 31, 32) zum Vergleichen der Amplituden des Drain-Stroms des Referenz-MOS-Transistors (QREF) mit dem Drain-Strom des Test-MOS-Transistors (QDDT) enthält.

**8.** Integrierte Halbleiterschaltungsvorrichtung nach Anspruch 7, dadurch gekennzeichnet, daß die Vergleichsschaltung (30, 31, 32) eine Vielzahl von Stromspiegelschaltungen (30, 31, 32) enthält, die jeweils eine Kombination eines Paars von MOS-Transistoren (Q6A, Q7A; Q6B, Q7B; Q8A, Q8B) enthalten.

**Revendications**

**1.** Circuit semi-conducteur intégré ayant une fonction de test et comprenant un circuit de traitement des signaux qui comporte une pluralité de composants à semi-conducteur intégrés sur une puce, dans lequel un circuit de test (20) est fourni sur ladite puce et comprend un composant à semi-conducteur de test ($Q_{DDT}$) ayant une taille égale à celle d'au moins un desdits composants à semi-conducteur ($Q_1$ à $Q_4$) et un composant à semi-conducteur de référence ($Q_{REF}$), ledit circuit de test (20) étant construit de manière à comparer les unes aux autres les caractéristiques dudit composant à semi-conducteur de test ($Q_{DDT}$) et dudit composant à semi-conducteur de référence ($Q_{REF}$) et à sortir un signal représentatif d'un résultat de la comparaison, caractérisé en ce que ledit composant à semi-conducteur de référence ($Q_{REF}$) a une taille différente de celle dudit composant à semi-conducteur de test ($Q_{DDT}$).

**2.** Circuit semi-conducteur intégré selon la revendication 1, caractérisé en ce que ledit circuit de test (20) et ledit circuit de traitement des signaux (10) sont connectés à une ligne de source d'alimentation commune (4) sur ladite puce.

**3.** Circuit semi-conducteur intégré selon la revendication 2, caractérisé en ce qu'il comprend en outre des moyens d'interruption (7) pouvant interrompre ledit circuit de test (20) à partir de ladite ligne de source d'alimentation (4) sur ladite puce.

**4.** Circuit semi-conducteur intégré selon la revendication 1, caractérisé en ce que la sortie dudit circuit de traitement des signaux (10) est commandée en réponse au signal de résultat de comparaison provenant dudit circuit de test (20).

**5.** Circuit semi-conducteur intégré selon la revendication 1, caractérisé en ce que ledit circuit de test (20) possède une borne de sortie (8) destinée à sortir le signal de résultat de comparaison vers l'extérieur.

**6.** Circuit semi-conducteur intégré selon la revendication 1, caractérisé en ce que lesdits composants à semi-conducteur ($Q_1$ à $Q_4$) formant ledit circuit de traitement des signaux (10), ledit composant à semi-conducteur de test ($Q_{DDT}$) et ledit composant à semi-conducteur de référence ($Q_{REF}$) sont des transistors MOS et la différence de taille entre ledit composant à semi-conducteur de test ($Q_{DDT}$) et ledit composant à semi-conducteur de référence ($Q_{REF}$) est la différence de longueur et de largeur entre les grilles des transistors MOS ($Q_{DDT}$, $Q_{REF}$).

**7.** Circuit semi-conducteur intégré selon la revendication 6, caractérisé en ce que le transistor MOS de référence ($Q_{REF}$) et le transistor MOS de test ($Q_{DDT}$) sont conçus de telle manière que la longueur et la largeur de la grille dudit transistor MOS de référence ($Q_{REF}$) soient plus grandes que la longueur et la largeur de la grille dudit transistor MOS de test ($Q_{DDT}$) et la conductance mutuelle dudit transistor MOS de référence ($Q_{REF}$) soit sensiblement égale à celle dudit transistor MOS de test ($Q_{DDT}$) et ledit circuit de test (20) comprend un circuit de comparaison (30, 31, 32) destiné à comparer les intensités du courant de drain dudit transistor MOS de référence ($Q_{REF}$) et du courant de drain dudit transistor MOS de test ($Q_{DDT}$).

**8.** Circuit semi-conducteur intégré selon la revendication 7, caractérisé en ce que ledit circuit de comparaison (30, 31, 32) comprend une pluralité de circuits à miroir de courant (30, 31, 32), comprenant chacun une combinaison d'une paire de transistors MOS ($Q_{6A}$, $Q_{7A}$ ; $Q_{6B}$, $Q_{7B}$ ; $Q_{8A}$, $Q_{8B}$).

# FIG.1(a)

# FIG.1(b)

# FIG.2

# FIG.3

# FIG.4